(19) **Europäisches Patentamt / European Patent Office / Office européen des brevets**

(11) **EP 3 226 424 A1**

(12) # EUROPEAN PATENT APPLICATION

(43) Date of publication:
**04.10.2017 Bulletin 2017/40**

(51) Int Cl.:
***H03M 13/35*** *(2006.01)*

(21) Application number: **17161971.1**

(22) Date of filing: **21.03.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **21.03.2016 KR 20160033210**

(71) Applicant: **Electronics and Telecommunications Research Institute**
**Daejeon 34129 (KR)**

(72) Inventors:
• **Baek, Myung-Sun**
 **34130 Daejeon (KR)**
• **Lee, Bong Ho**
 **35367 Daejeon (KR)**
• **Yang, Kyu Tae**
 **34048 Daejeon (KR)**
• **Lim, Hyoungsoo**
 **34049 Daejeon (KR)**
• **Hur, Namho**
 **30064 Sejong-si (KR)**

(74) Representative: **Betten & Resch**
**Patent- und Rechtsanwälte PartGmbB**
**Maximiliansplatz 14**
**80333 München (DE)**

(54) **APPARATUS AND METHOD FOR VARIABLE CHANNEL CODING**

(57)     Provided is an apparatus for variable channel coding that sets a coding rate of an outer code and an audio frame length to be variable, the apparatus including an audio coder (310) configured to code input audio data using a first codec, and a processor (320) configured to generate a first frame having a super frame structure of a length corresponding to the first codec based on the coded audio data (321), and apply an error correction code to the generated first frame (322). Preferably, the first codec is of the type HE-AAC v2 (High Efficiency Advanced Audio Coding), SAOC (Spatial Audio Object Coding) or USAC (Unified Speech and Audio Coding) and the error correction code is a low-density parity check (LDPC) code or a turbo code. The apparatus may applied within the DAB+ framework.

**FIG. 3**

**Description**

BACKGROUND

1. Field

One or more example embodiments relate to technology for variable channel coding with respect to an audio signal for digital broadcasting, and more particularly, to an apparatus and method for improving the performance and efficiency of a digital audio broadcasting (DAB) system by setting a coding rate of an outer code and an audio frame length to be variable.

2. Description of Related Art

In general, a digital communication system uses a channel coder to reduce a bit error rate (BER) of a signal. In particular, many digital audio broadcasting (DAB) systems use convolution codes or Reed-Solomon codes as outer codes to improve reliability in a channel coding process.

However, the convolution codes and the Reed-Solomon codes have poor error correction functions when compared to channel codes such as turbo codes or low-density parity-check (LDPC) codes. Further, when performing channel coding using the Reed-Solomon codes as the outer codes, a single fixed coding rate is used, and thus it is impossible to flexibility apply a variable coding rate based on a frame unit or significance of an input signal. To improve the receiving efficiency of the DAB systems and the error correction function in the channel coding process, a high-performance flexible channel coding scheme that may set a coding rate of an outer code and an audio frame length to be variable based on an audio codec applied to an input signal and adaptively set the coding rate based on a significance of content needs to be applied.

SUMMARY

According to an aspect, there is provided an apparatus for variable channel coding that may set a coding rate of an outer code and an audio frame length to be variable. The apparatus may include an audio coder configured to code input audio data using a first codec, and a processor configured to generate a first frame having a super frame structure of a length corresponding to the first codec based on the coded audio data, and apply an error correction code to the generated first frame.

The first codec may include at least one of a High-Efficiency Advanced Audio Coding version2 (HE-AAC v2) codec, a Spatial Audio Object Coding (SAOC) codec, or a Unified Speech and Audio Coding (USAC) codec.

The error correction code may include at least one of a low-density parity-check (LDPC) code or a turbo code.

The processor may include a frame generator configured to generate the first frame by converting the coded audio data into a super frame structure of a length corresponding to a bit rate of the first codec, and a channel coder configured to set a coding rate to be variable based on a length of the first frame and apply the coding rate to the first frame.

The channel coder may be configured to differentially apply the coding rate based on a content significance included in the audio data.

The apparatus may further include a multiplexer configured to select at least one of a plurality of broadcasting service channels and transmit the first frame through the selected at least one broadcasting service channel.

According to another aspect, there is also provided an apparatus for variable channel coding that may set a coding rate of an outer code and an audio frame length to be variable. The apparatus may include a frame generator configured to set a frame length to be variable so as to correspond to a bit rate of a first codec applied to an input audio signal, and generate a first frame based on the audio signal, and a channel coder configured to apply a variable coding rate to the first frame based on at least one of a content significance or a length of the first frame.

The first codec comprises at least one of an HE-AAC v2 codec, an SAOC codec, or a USAC codec.

The channel coder may be configured to apply at least one of an LDPC code or a turbo code to the first frame.

The channel coder may be configured to apply a first coding rate to the first frame when the audio signal corresponds to regular broadcast data, and apply a second coding rate which is greater than the first coding rate to the first frame when the audio signal corresponds to emergency broadcast data.

According to still another aspect, there is also provided a method for variable channel coding that may set a coding rate of an outer code and an audio frame length to be variable. The method may include coding input audio data using a first codec, generating a first frame having a super frame structure of a length corresponding to the first codec based on the coded audio data, and applying an error correction code to the generated first frame.

The first codec may include at least one of an HE-AAC v2 codec, an SAOC codec, or a USAC codec.

The error correction code may include at least one of an LDPC code or a turbo code.

The generating may include generating the first frame by converting the coded audio data into a super frame structure of a length corresponding to a bit rate of the first codec.

The applying may include setting a coding rate to be variable based on a length of the first frame and applying the coding rate to the first frame.

The applying may include differentially applying the coding rate based on a content significance included in the audio data.

The method may further include selecting at least one of a plurality of broadcasting service channels and transmitting the first frame through the selected at least one broadcasting service channel.

Additional aspects of example embodiments will be set forth in part in the description which follows and, in part, will be apparent from the description, or may be learned by practice of the disclosure.

BRIEF DESCRIPTION OF THE DRAWINGS

These and/or other aspects, features, and advantages of the invention will become apparent and more readily appreciated from the following description of example embodiments, taken in conjunction with the accompanying drawings of which:

> FIG. 1 is a diagram illustrating a general process of processing a digital audio broadcast signal;
> FIG. 2 is a block diagram illustrating an apparatus for variable channel coding according to an example embodiment;
> FIG. 3 is a diagram illustrating a process of processing a digital audio broadcast signal using a method for variable channel coding according to an example embodiment;
> FIG. 4 is a diagram illustrating an audio super frame structure generated by applying a variable length according to an example embodiment;
> FIG. 5 is a diagram illustrating a method of applying a variable coding rate based on a content significance according to an example embodiment;
> FIG. 6 is a diagram illustrating an outer code to be used to process input frames of various lengths according to an example embodiment; and
> FIG. 7 is a flowchart illustrating a method for variable channel coding according to an example embodiment.

DETAILED DESCRIPTION

The following detailed structural or functional description of example embodiments is provided as an example only and various alterations and modifications may be made to the example embodiments. Accordingly, the example embodiments are not construed as being limited to the disclosure and should be understood to include all changes, equivalents, and replacements within the technical scope of the disclosure.

Terms, such as first, second, and the like, may be used herein to describe components. Each of these terminologies is not used to define an essence, order or sequence of a corresponding component but used merely to distinguish the corresponding component from other component(s). For example, a first component may be referred to as a second component, and similarly the second component may also be referred to as the first component.

In case it is mentioned that a certain component is "connected" or "accessed" to another component, it may be understood that the certain component is directly connected or accessed to the another component or that a component is interposed between the components. On the contrary, in case it is mentioned that a certain component is "directly connected" or "directly accessed" to another component, it should be understood that there is no component therebetween.

Terms used herein is to merely explain specific embodiments, thus it is not meant to be limiting. A singular expression includes a plural expression except that two expressions are contextually different from each other. In the present disclosure, a term "include" or "have" is intended to indicate that characteristics, figures, steps, operations, components, elements disclosed on the specification or combinations thereof exist. Rather, the term "include" or "have" should be understood so as not to pre-exclude existence of one or more other characteristics, figures, steps, operations, components, elements or combinations thereof or additional possibility.

Unless otherwise defined, all terms, including technical and scientific terms, used herein have the same meaning as commonly understood by one of ordinary skill in the art to which this disclosure pertains. Terms, such as those defined in commonly used dictionaries, are to be interpreted as having a meaning that is consistent with their meaning in the context of the relevant art, and are not to be interpreted in an idealized or overly formal sense unless expressly so defined herein.

Hereinafter, reference will now be made in detail to the example embodiments, examples of which are illustrated in the accompanying drawings, wherein like reference numerals refer to the like elements throughout.

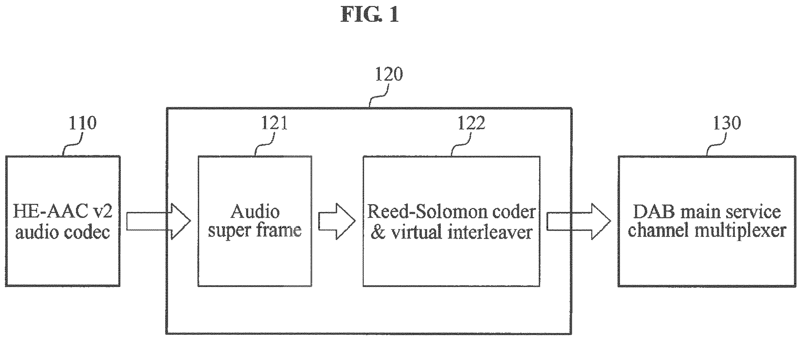

FIG. 1 is a diagram illustrating a general process of processing a digital audio broadcast signal.

In general, a digital audio broadcasting (DAB) system codes an audio signal using a High-Efficiency Advanced Audio Coding version2 (HE-AAC v2) codec 110 which is a representative audio coder, and inputs the coded audio signal into a signal processing block 120 for processing. The input coded audio signal is configured as an audio super frame 121 of a fixed length, and transmitted in predetermined time units, for example, units of 120 milliseconds (msec).

Recently, with the development of technology, an audio codec such as a Unified Speech and Audio Coding (USAC) codec, which is more excellent than the existing HE-AAC v2, has been developed. However, since an existing audio super frame is generated with a fixed length, it is difficult to support various input bit rates although a new audio codec is applied, and thus application of the audio codec having excellent performance when compared to the existing audio codec is limited.

Further, when considering that a radio broadcast is listened to mainly in a vehicle, application of a channel coder having an excellent error correction function is needed to improve the mobile receiving performance. However, the general DAB system performs channel coding with respect to the audio super frame 121 using a Reed-Solomon coder and virtual interleaver 122, and transmits the audio super frame 121 through a channel selected by a DAB main service channel multiplexer 130. In this process, Reed-Solomon codes used as outer codes have a poor error correction function when compared to turbo codes or channel codes such as low-density parity-check (LDPC) codes, and have a single fixed coding rate. Thus, it is impossible to flexibly apply a variable coding rate based on a frame unit or significance of the input signal.

Accordingly, to support various audio codecs in a signal processing process of a DAB system and improve the receiving performance, a channel coding scheme that sets a coding rate of an outer code and an audio frame length to be variable based on an audio codec applied to an input signal is needed.

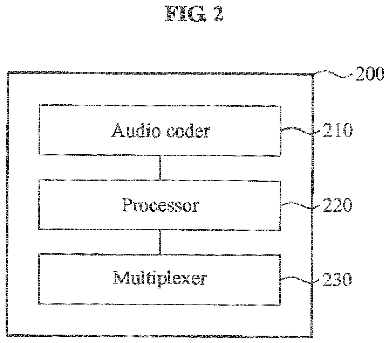

FIG. 2 is a block diagram illustrating an apparatus for variable channel coding according to an example embodiment.

Referring to FIG. 2, an apparatus 200 for variable channel coding may include an audio coder 210, a processor 220, and a multiplexer 230 as constituents to set a coding rate of an outer code and an audio frame length to be variable. However, the multiplexer 230 is an optional constituent, and thus may be omitted in an embodiment.

The audio coder 210 may code input audio data using a first codec. Here, the first codec may include at least one of an HE-AAC v2 codec, a Spatial Audio Object Coding (SAOC) codec, or a USAC codec.

The processor 220 may generate a first frame having a super frame structure of a length corresponding to the first codec based on the coded audio data, and apply an error correction code to the generated first frame. In this example, the error correction code may include at least one of an LDPC code or a turbo code.

In detail, the processor 220 may include a frame generator (not shown) configured to generate the first frame, and a channel coder (not shown) configured to perform channel coding by applying the error correction code to the first frame. The frame generator may generate the first frame based on the coded audio data by setting a frame length to be variable so as to correspond to a bit rate of the first codec, and the channel coder may set a coding rate to be variable based on a length of the first frame and apply the coding rate to the first frame. The channel coder may differentially apply the coding rate based on a content significance included in the audio data. For example, when the audio data corresponds to regular broadcast data, the channel coder may determine the content significance to be "moderate", and apply a first coding rate to the first frame. However, when the audio data corresponds to special broadcast data related to an emergency alert broadcast or a presidential speech, the channel coder may determine the content significance to be "high", and apply a second coding rate which is greater than the first coding rate to the first frame such that a higher error correction function may be provided.

The multiplexer 230 may select at least one of a plurality of broadcasting service channels and transmit the first frame through the selected at least one broadcasting service channel.

The apparatus 200 for variable channel coding may set a coding rate of an outer code and an audio frame length to be variable and change the outer code of a DAB system to a code having an excellent error correction performance, thereby applying an improved audio codec and further improving the receiving performance and efficiency of the DAB system.

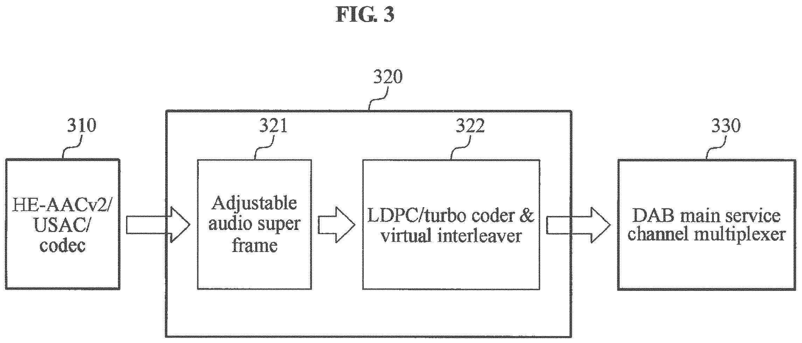

FIG. 3 is a diagram illustrating a process of processing a digital audio broadcast signal using a method for variable channel coding according to an example embodiment.

Referring to FIG. 3, similar to the general DAB system of FIG. 1, a DAB system may code an audio signal using an audio codec 310, input the coded audio signal into a signal processing block 320 for processing, and transmit the audio signal through a channel selected by a DAB main server channel multiplexer 330. However, the DAB system of FIG. 3 differs from the general DAB system of FIG. 1 in that the DAB system of FIG. 3 applies an outer code that simultaneously supports various audio codecs and provides a more excellent error correction function.

In the DAB system of FIG. 3, the audio signal may be coded using various audio codecs such as an SAOC codec and a USAC codec, in addition to the existing HE-AAC v2 codec. The coded audio signal may be input into the signal processing block 320, and configured as an adjustable audio super frame 321 having a variable length based on a bit rate of the applied audio codec.

Further, the DAB system of FIG. 3 may apply an LDPC code or a turbo code instead of the existing Reed-Solomon code. In a case of the existing Reed-Solomon code, a fixed coding rate may cause a delay in a process of processing an audio super frame or a frame of a variable length may not be applied, and an error correction function may be relatively poor. Conversely, an LDPC/turbo coder and virtual interleaver 322 may set a coding rate to be variable while providing a more excellent error correction function, thereby flexibly handling an input of the adjustable audio super frame 321. Further, the LDPC/turbo coder and virtual interleaver 322 may also differentially set and apply the coding rate based on a content significant of the audio signal.

The DAB system of FIG. 3 may set a coding rate of an outer code and an audio frame length to be variable, thereby supporting various audio codecs and improving the mobile receiving performance of a radio broadcast.

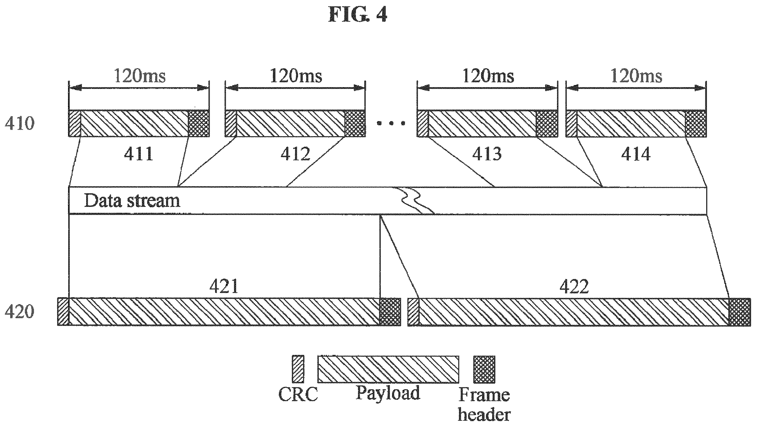

FIG. 4 is a diagram illustrating an audio super frame structure generated by applying a variable length according to an example embodiment.

In a process of transmitting a data stream, a structure including super frames 411, 412, 413, and 414 supporting fixed lengths of 120 ms used in general may process a limited bit rate, and thus may have a limitation in supporting various audio codecs. Further, as shown in FIG. 4, in a case in which a large volume of the data stream is to be transmitted, an overhead such as cyclic redundancy check (CRC) and a header may increase in the super frame structure of the fixed size, and thus the transmission efficiency may decrease.

Conversely, in a case in which super frames 421 and 422 of variable lengths set to be relatively long are input into forward error correction (FEC), an overhead such as CRC and a header may greatly decrease when compared to the super frames 411 through 414 of the fixed lengths, and thus the system efficiency may improve. Further, in a case of the super frames 421 and 422 of variable lengths, a frame length may be set to be variable based on a codec to be applied, and thus various bit rates may be processed. Accordingly, it is not limited to any one audio codec, and types of audio codecs to be applied to the audio data may be extended.

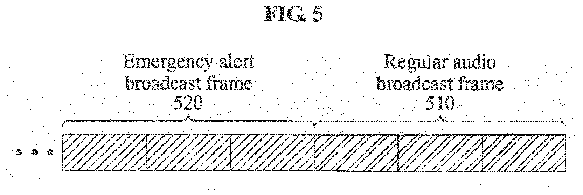

FIG. 5 is a diagram illustrating a method of applying a variable coding rate based on a content significance according to an example embodiment.

In a case of using Reed-Solomon codes as outer codes in a channel coding process, codes may be generated by a generator polynomial of Equation 1 and only a fixed coding rate of RS(120, 110, t=5) may be applied.

[Equation 1]

$$G(x) = \prod_{i=0}^{9} (x + \alpha^i)$$

As shown above, the fixed coding rate may cause a delay in a process of processing an audio super frame. It is impossible to apply an audio super frame of a variable length, and thus various audio codecs may not be supported. Further, an error correction function of a Reed-Solomon encoder is relatively poor when compared to LDPC codes or turbo codes, and thus it may be difficult to expect an excellent error correction performance.

To solve such an issue, a scheme of using the LDPC codes or the turbo codes that support an excellent error correction performance as outer codes may be considered instead of the existing Reed-Solomon codes. Further, when a coding rate of an outer code is set to be variable, rather than to be fixed, it is possible to flexibly handle an input of an audio super frame of a variable length.

Furthermore, an example of differently applying the coding rate of the outer code based on a content significance of the audio data may also be implemented. For example, audio data with a "moderate" content significant, such as regular broadcast data, may be coded using a general coding rate. However, a coding rate which is higher than the general coding rate may be applied to audio data with a "high" content significance, such as data related to an emergency alert broadcast, a presidential speech, or a promotional broadcast for the public, whereby the error correction performance may increase and a transmission error rate of a signal may decrease.

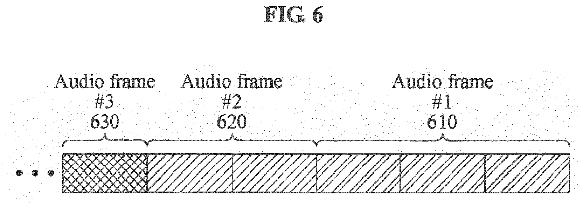

FIG 6 is a diagram illustrating an outer code to be used to process input frames of various lengths according to an example embodiment.

As shown in FIG. 6, a frame length to be input into an encoder in a channel coding process may be set to be variable, rather than to be fixed. In general, a frame length for easy signal processing may differ based on a type of an audio codec. Thus, when an audio codec to be applied to audio data is changed, a length of an audio super frame may also be set to be variable.

An outer code of FIG. 6 may set a length to be variable for each audio frame 610, 620, 630 to be input into the encoder, thereby supporting various audio codecs to be applied. As described above, when a variable frame and a variable coding rate are applied in the channel coding process, an audio quality may improve and various gains may be achieved in response to reduction of overhead.

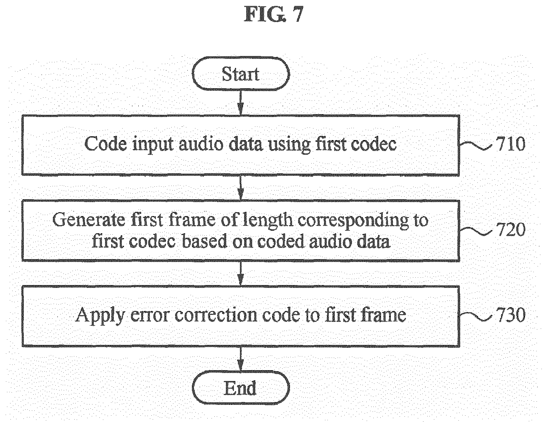

FIG. 7 is a flowchart illustrating a method for variable channel coding according to an example embodiment.

An apparatus for variable channel coding may set a coding rate of an outer code and an audio frame length to be variable and change the outer code of a DAB system to a code with excellent error correction performance, thereby applying an improved audio codec. Further, a method of improving the receiving performance and efficiency of the DAB system may be provided.

In operation 710, an audio coder of the apparatus for variable channel coding may code input audio data using a first codec. The first codec may include at least one of an HE-AAC v2 codec, an SAOC codec, or a USAC codec.

In operation 720, a processor of the apparatus for variable channel coding may generate a first frame having a super frame structure of a length corresponding to the first codec. The processor may generate the first frame based on the coded audio data by setting a frame length to be variable so as to correspond to a bit rate of the first codec.

In operation 730, the processor may apply an error correction code to the generated first frame. The error correction code may include at least one of an LDPC code or a turbo code. The processor may set a coding rate to be variable based on a length of the first frame and apply the coding rate to the first frame. In an example, the processor may differentially apply the coding rate based on a content significance included in the audio data. For example, when the audio data corresponds to regular broadcast data, the processor may determine the content significant to be "moderate", and apply a first coding rate to the first frame. However, when the audio data corresponds to special broadcast data related to an emergency alert broadcast or a presidential speech, the processor may determine the content significance to be "high", and apply a second coding rate which is greater than the first coding rate to the first frame such that a higher error correction function may be provided. A multiplexer of the apparatus for variable channel coding may select at least one of a plurality of broadcasting service channels and transmit the first frame through the selected at least one broadcasting service channel.

The components described in the exemplary embodiments of the present invention may be achieved by hardware components including at least one Digital Signal Processor (DSP), a processor, a controller, an Application Specific Integrated Circuit (ASIC), a programmable logic element such as a Field Programmable Gate Array (FPGA), other electronic devices, and combinations thereof At least some of the functions or the processes described in the exemplary embodiments of the present invention may be achieved by software, and the software may be recorded on a recording medium. The components, the functions, and the processes described in the exemplary embodiments of the present invention may be achieved by a combination of hardware and software.

The units described herein may be implemented using hardware components and software components. For example, the hardware components may include microphones, amplifiers, band-pass filters, audio to digital convertors, non-transitory computer memory and processing devices. A processing device may be implemented using one or more general-purpose or special purpose computers, such as, for example, a processor, a controller and an arithmetic logic unit, a digital signal processor, a microcomputer, a field programmable array, a programmable logic unit, a microprocessor or any other device capable of responding to and executing instructions in a defined manner. The processing device may run an operating system (OS) and one or more software applications that run on the OS. The processing device also may access, store, manipulate, process, and create data in response to execution of the software. For purpose of simplicity, the description of a processing device is used as singular; however, one skilled in the art will appreciated that a processing device may include multiple processing elements and multiple types of processing elements. For example, a processing device may include multiple processors or a processor and a controller. In addition, different processing configurations are possible, such as parallel processors.

The software may include a computer program, a piece of code, an instruction, or some combination thereof, to independently or collectively instruct or configure the processing device to operate as desired. Software and data may be embodied permanently or temporarily in any type of machine, component, physical or virtual equipment, computer storage medium or device, or in a propagated signal wave capable of providing instructions or data to or being interpreted by the processing device. The software also may be distributed over network coupled computer systems so that the software is stored and executed in a distributed fashion. The software and data may be stored by one or more non-transitory computer readable recording mediums.

The method according to the above-described example embodiments may be recorded in non-transitory computer-readable media including program instructions to implement various operations of the above-described example embodiments. The media may also include, alone or in combination with the program instructions, data files, data structures, and the like. The program instructions recorded on the media may be those specially designed and constructed for the purposes of example embodiments, or they may be of the kind well-known and available to those having skill in the computer software arts. Examples of non-transitory computer-readable media include magnetic media such as hard disks, floppy disks, and magnetic tape; optical media such as CD-ROM discs, DVDs, and/or Blue-ray discs; magneto-optical media such as optical discs; and hardware devices that are specially configured to store and perform program instructions, such as read-only memory (ROM), random access memory (RAM), flash memory (e.g., USB flash drives, memory cards, memory sticks, etc.), and the like. Examples of program instructions include both machine code, such as produced by a compiler, and files containing higher level code that may be executed by the computer using an interpreter. The above-described devices may be configured to act as one or more software modules in order to perform the operations of the above-described example embodiments, or vice versa.

A number of example embodiments have been described above. Nevertheless, it should be understood that various modifications may be made to these example embodiments. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

**Claims**

1.   An apparatus for variable channel coding, the apparatus comprising:

an audio coder configured to code input audio data using a first codec; and

a processor configured to generate a first frame having a super frame structure of a length corresponding to the first codec based on the coded audio data, and apply an error correction code to the generated first frame.

2. The apparatus of claim 1, wherein the first codec comprises at least one of a High-Efficiency Advanced Audio Coding version2 (HE-AAC v2) codec, a Spatial Audio Object Coding (SAOC) codec, or a Unified Speech and Audio Coding (USAC) codec.

3. The apparatus of claims 1 or 2, wherein the error correction code comprises at least one of a low-density parity-check (LDPC) code or a turbo code.

4. The apparatus of claim 1, 2 or 3, wherein the processor comprises:

   a frame generator configured to generate the first frame by converting the coded audio data into a super frame structure of a length corresponding to a bit rate of the first codec; and
   a channel coder configured to set a coding rate to be variable based on a length of the first frame and apply the coding rate to the first frame.

5. The apparatus of claim 4, wherein the channel coder is configured to differentially apply the coding rate based on a content significance included in the audio data.

6. The apparatus of one of claims 1 to 5, further comprising:

   a multiplexer configured to select at least one of a plurality of broadcasting service channels and transmit the first frame through the selected at least one broadcasting service channel.

7. An apparatus for variable channel coding, the apparatus comprising:

   a frame generator configured to set a frame length to be variable so as to correspond to a bit rate of a first codec applied to an input audio signal, and generate a first frame based on the audio signal; and
   a channel coder configured to apply a variable coding rate to the first frame based on at least one of a content significance or a length of the first frame.

8. The apparatus of claim 7, wherein the first codec comprises at least one of a High-Efficiency Advanced Audio Coding version2 (HE-AAC v2) codec, a Spatial Audio Object Coding (SAOC) codec, or a Unified Speech and Audio Coding (USAC) codec.

9. The apparatus of claim 7 or 8, wherein the channel coder is configured to apply at least one of a low-density parity-check (LDPC) code or a turbo code to the first frame.

10. The apparatus of claim 7, 8 or 9, wherein the channel coder is configured to apply a first coding rate to the first frame when the audio signal corresponds to regular broadcast data, and apply a second coding rate which is greater than the first coding rate to the first frame when the audio signal corresponds to emergency broadcast data.

11. A method for variable channel coding, the method comprising:

    coding input audio data using a first codec;
    generating a first frame having a super frame structure of a length corresponding to the first codec based on the coded audio data; and
    applying an error correction code to the generated first frame.

12. The method of claim 11, wherein the first codec comprises at least one of a High-Efficiency Advanced Audio Coding version2 (HE-AAC v2) codec, a Spatial Audio Object Coding (SAOC) codec, or a Unified Speech and Audio Coding (USAC) codec.

13. The method of claim 11 or 12, wherein the error correction code comprises at least one of a low-density parity-check (LDPC) code or a turbo code.

14. The method of claim 11, 12 or 13, wherein the generating comprises generating the first frame by converting the coded audio data into a super frame structure of a length corresponding to a bit rate of the first codec.

15. The method of one of claims 11 to 14, wherein the applying comprises setting a coding rate to be variable based on a length of the first frame and applying the coding rate to the first frame.

**FIG. 1**

**FIG. 2**

EP 3 226 424 A1

**FIG. 3**

```
                                        320
                                         |
   310                    321                    322              330
    |                      |                       |                |
┌──────────┐        ┌────────────┐   ┌──────────────────┐   ┌──────────────────┐
│HE-AACv2/ │   ⇒    │ Adjustable │ ⇒ │LDPC/turbo coder &│ ⇒ │ DAB main service │
│  USAC/   │        │audio super │   │virtual interleaver│   │channel multiplexer│
│  codec   │        │   frame    │   └──────────────────┘   └──────────────────┘
└──────────┘        └────────────┘
```

FIG. 4

## FIG. 5

Emergency alert
broadcast frame
520

Regular audio
broadcast frame
510

EP 3 226 424 A1

FIG. 6

Audio frame    Audio frame        Audio frame
     #3            #2                 #1
    630          620                610

## FIG. 7

```
           ( Start )
               │
               ▼
┌──────────────────────────────────────┐
│  Code input audio data using first codec │ ~710
└──────────────────────────────────────┘
               │
               ▼
┌──────────────────────────────────────┐
│  Generate first frame of length corresponding to │ ~720
│  first codec based on coded audio data │
└──────────────────────────────────────┘
               │
               ▼
┌──────────────────────────────────────┐
│  Apply error correction code to first frame │ ~730
└──────────────────────────────────────┘
               │
               ▼
           ( End )
```

Europäisches
Patentamt

European
Patent Office

Office européen
des brevets

**EUROPEAN SEARCH REPORT**

Application Number

EP 17 16 1971

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ETSI: "ETSI TS 102 563 V1.2.1 Digital Audio Broadcasting (DAB); Transport of Advanced Audio Coding (AAC)", , 31 May 2005 (2005-05-31), pages 1-27, XP055103611, Retrieved from the Internet: URL:http://www.etsi.org/deliver/etsi_ts/10 2500_102599/102563/01.02.01_60/ts_102563v0 10201p.pdf [retrieved on 2014-02-21] | 1,2,6, 11,12 | INV. H03M13/35 |
| Y | * page 5 * | 8 | |
| A | * pages 7,8 * * pages 15,16 * * figure 1 * ----- | 3-5,7,9, 10,13-15 | |
| X | "Radio Broadcasting Systems; Digital Audio Broadcasting (DAB) to mobile, portable and fixed receivers European Broadcasting Union Union Européenne de Radio-Télévision EBUÜER; ETSI EN 300 401", IEEE, LIS, SOPHIA ANTIPOLIS CEDEX, FRANCE, vol. BC, no. V1.4.1, 1 June 2006 (2006-06-01), XP014034038, ISSN: 0000-0001 | 1,4-7, 11,14,15 | |
| Y | * page 22 * | 8,9 | |
| A | * page 127 - page 128 * * page 133 - page 137 * * figure 1 * * tables 31,32 * ----- -/-- | 2,3,10, 12,13 | |

| | TECHNICAL FIELDS SEARCHED (IPC) |
|---|---|
| | H03M H04L H04H |

The present search report has been drawn up for all claims

| Place of search | Date of completion of the search | Examiner |
|---|---|---|
| Munich | 24 August 2017 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 17 16 1971

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | VIGIL A J: "Wireless data transmission through in-band on-channel digital audio broadcasting", PROC. OF SPIE, OPTOMECHATRONIC MICRO/NANO DEVICES AND COMPONENTS III, 8 - 10 OCTOBER 2007, LAUSANNE, SWITZERLAND, vol. 2601, 23 October 1995 (1995-10-23), pages 105-114, XP002106406, DOI: 10.1117/12.228132 ISBN: 978-1-62841-730-2 * page 105 - page 108 * | 1,11 | |
| X | KIM H ED - INSTITUTE OF ELECTRICAL AND ELECTRONICS ENGINEERS: "TURBO CODED ORTHOGONAL FREQUENCY DIVISION MULTIPLEXING FOR DIGITAL AUDIO BROADCASTING", PROC. IEEE INTERNATIONAL CONFERENCE ON COMMUNICATIONS 2000 (ICC 2000), NEW ORLEANS, LA, USA, JUNE 18-21, 2000, 18 June 2000 (2000-06-18), pages 420-424, XP001042982, ISBN: 978-0-7803-6284-0 | 1,3,11, 13 | |
| Y | * abstract * * page 420, left-hand column - page 423, right-hand column * * figures 1,2 * * tables II,IV,V * | 9 | TECHNICAL FIELDS SEARCHED (IPC) |

-/--

The present search report has been drawn up for all claims

| Place of search | Date of completion of the search | Examiner |
|---|---|---|
| Munich | 24 August 2017 | Burkert, Frank |

EPO FORM 1503 03.82 (P04C01)

Europäisches
Patentamt

European
Patent Office

Office européen
des brevets

## EUROPEAN SEARCH REPORT

Application Number

EP 17 16 1971

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HINDELANG T ET AL: "CHANNEL CODING TECHNIQUES FOR ADAPTIVE MULTI RATE SPEECH TRANSMISSION", PROC. IEEE INTERNATIONAL CONFERENCE ON COMMUNICATIONS 2000 (ICC 2000), NEW ORLEANS, LA, USA, JUNE 18-21, 2000, vol. 2, 18 June 2000 (2000-06-18), pages 744-748, XP001208750, ISBN: 978-0-7803-6284-0 * abstract * * page 744 - right-hand column * * figure 1 * ----- | 1,11 | |

TECHNICAL FIELDS
SEARCHED      (IPC)

The present search report has been drawn up for all claims

| Place of search | Date of completion of the search | Examiner |
|---|---|---|
| Munich | 24 August 2017 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)